# EUROPEAN PATENT SPECIFICATION

(11) **EP 3 407 690 B1**
(45) Date of publication and mention of the grant of the patent: **12.01.2022**
(21) Application number: 17172115.2
(22) Date of filing: 22.05.2017
(51) Int. Cl.: H05K 7/20

(54) **HEAT EXCHANGER FOR COOLING AN ELECTRONIC ENCLOSURE**
WÄRMETAUSCHER ZUR KÜHLUNG EINES ELEKTRONISCHEN GEHÄUSES
ÉCHANGEUR DE CHALEUR POUR LE REFROIDISSEMENT D'UN BOÎTIER ÉLECTRONIQUE

(43) Date of publication of application: 28.11.2018
(73) Proprietor: Pfannenberg GmbH, 21035 Hamburg (DE)
(72) Inventor: Fuller, Russell, Lancaster, New York 14086 (US)
(74) Representative: RGTH

(56) References cited:
- CN-U- 202 814 177
- US-A- 4 475 358
- US-A1- 2009 284 925
- US-A1- 2010 185 332
- US-A1- 2010 300 143
- US-A1- 2016 341 459
- US-B2- 6 382 308

## Description

### Field of the invention

The present invention relates to a heat exchanger for cooling an electronic enclosure. Further, the invention is concerned a use of a heat exchanger for cooling an electronic enclosure.

US 2009/284925 A1 discloses an evaporator for a cooling unit having a channel and a separation volume.

US 2016/0341459 A1 discloses a two chamber heat transfer unit configured such that hazardous air can circulate through one of the chambers of the heat transfer unit and any potential ignition source components are contained in another pressurized chamber of the heat transfer unit.

In US 2010/0185332 A1 a system and method for climate control of an enclosure that includes two climate control systems configured to operate in conjunction to cool the enclosure are disclosed.

US 4,475,358 A relates to an air conditioner for cooling electrical parts which are situated in a cabinet wherein a coolant circulation consists of an evaporator, a condenser and a compressor.

US 2010/0300143 discloses a liquid separator, designed as a U-shaped pipe and arranged essentially horizontally, for a plate heat exchanger evaporator system for separation of liquid drop lets from vapour transported from the evaporator to the separator.

CN 202 814 177 U relates to a heat pipe heat exchanging system with circulation pump. US6382308B2 discloses a heat exchanger according to the preamble of the independent claim 1.

### Summary of the invention

The present invention suggests a heat exchanger for cooling an electronic enclosure according to the independent claim 1, the heat exchanger comprising a condenser side and an evaporator side. Furthermore, the heat exchanger comprises a heat exchanging element having a condenser unit and an evaporator unit. The evaporator unit comprises a lower end area, an upper end area as well as a plurality of channels for transporting a refrigerant from the lower end area to the upper end area, wherein the refrigerant comprises liquid and gas. The upper end area of the evaporator unit is connected to its lower end area by a first line which is configured to transfer only liquid from the upper end area to the lower area. The condenser unit and the evaporator unit are arranged such that the condenser unit and the evaporator unit overlap vertically.

The heat exchanger is preferably an air-to-air heat exchanger. The heat exchanger acts as an electronic enclosure cooling unit.

The term "electronic enclosure" especially refers to an enclosure of electronic equipment which produces a heat load, such as e.g. a switch cabinet. Preferably, the electronic enclosure is characterized by the feature that the ambient temperature, i.e. the temperature outside of the electronic enclosure, is lower than the interior temperature, i.e. the temperature inside the electronic enclosure.

The electronic enclosure enclosures could be placed inside or outside. Outside applications would for example include waste water management or telecommunication shelters, wherein indoor applications could for example include wash-down scenarios (for example in the food and beverage industry) or scenarios where a high level of corrosion safety has to be guaranteed. Generally speaking, the heat exchanger according to the invention can be applied in any electronic enclosure cooling scenario where the ambient temperature is lower than the interior temperature. Thus, the heat exchanger is in particular configured to be used for indoor applications as well as outdoor applications.

In particular, the heat exchanger comprises a casing defining an inside and an outside of the heat exchanger, wherein the evaporator side and the condenser side are placed in the inside of the heat exchanger. The casing of the heat exchanger is preferably attachable, further preferred attached, to the outside of the electronic enclosure, especially to a casing of the electronic enclosure.

The evaporator unit is preferably disposed on the evaporator side of the heat exchanger, while the condenser unit is advantageously disposed at the condenser side.

The evaporator unit comprises a plurality of channels. These channels are preferably of capillary dimension. The channels are advantageously configured as micro-channels.

The channels can preferably be configured as being ports of a larger mini-channel. In particular, the invention comprises multiple mini-channels. Preferably, the evaporator unit has 5 to 20, preferably 7 to 15, further preferred 9 to 12, most preferred 10 mini-channels. A mini-channel preferably has a substantially rectangular shape in cross direction wherein the channels which it comprises are aligned within the mini-channel in a straight way. This alignment results in the substantially rectangular shape of the mini-channel. Each mini-channel preferably has 2 to 25, further preferred 4 to 10, most preferred 5 to 7, channels. In particular, a mini-channel has 6 channels. In particular, the evaporator unit is configured as a micro-channel heat exchanger. Advantageously, each mini-channel has a shorter cross dimension of between 0,1 mm and 12 mm, preferably between 0,2 mm and 10 mm, further preferred between 0,4 mm and 6 mm, most preferred between 2 mm and 5 mm, while the larger cross dimension lies between 0,6 mm and 240 mm, preferably between 1,2 mm and 200 mm, further preferred between 2,4 mm and 120 mm, most preferred between 12 mm and 100 mm.

In particular, the channels are partially filled with a refrigerant comprising liquid and gas. This refrigerant is preferably a two-phase refrigerant which is present within the channels in a liquid state and a gaseous state. The filling ratio of the channels is between 10% and 95%, especially between 30% and 80%. Further preferred, the filling ratio is between 50% and 80%, especially between 50 % to 75%. These filling ratios improve the performance of the heat exchanger. The channels which are filled by means of fill ports which allow the heat exchanging element to be evacuated and partially filled with the refrigerant.

Most preferred the refrigerant is R-134A. The refrigerant is configured such that it does no create any reaction with the material of the heat exchanger and does not create any non-condensable gas. Furthermore, the refrigerant is configured such the heat exchanger has enough strength to endure the gas pressure of the refrigerant used.

The feature that the two-phase refrigerant is present within the channels in a gaseous state and a liquid state means that the channels are filled with liquid and gas, namely liquid parts and gaseous parts of the two-phase refrigerant, which do not form a continuous phase respectively. Rather, the liquid parts and gaseous parts are intermixed. The gaseous parts are formed by gas bubbles, while the liquid parts are formed by drops or larger accumulations of liquid.

Particularly, the condenser side is located higher than the evaporator side. The lower end area of the evaporator unit is preferably arranged at the lower height than the upper end area so that an upper end of the evaporator unit is located lower than an upper end of the condenser unit. However, the condenser side is preferably not located entirely above the evaporator side in a vertical direction but according to the invention the condenser unit and the evaporator unit are arranged such that the condenser unit and the evaporator unit overlap vertically. In other words, the length of the heat exchanger is smaller than the sum of the lengths of the condenser unit and the evaporator unit. The overlap, i.e. the length of the vertical overlap the condenser unit and the evaporator unit compared to the length of the heat exchanger, can be between 0 and 1,0, preferably between 0,1 and 0,9, more preferred between 0,3 and 0,7. Therefore, the evaporator unit and the condenser unit can e.g. be arranged in vertical direction next to each other.

The channels preferably extend in a straight way from the lower end area to the upper end area. In particular, the evaporator unit is configured such that the channels extent in vertical direction. The channels preferably have a first end being disposed in the lower end area of the evaporator unit and a second end being disposed in an upper end area.

The upper end area and/or the lower end area of the evaporator unit can be of any shape or size. In particular, the lower end area and/or the upper end area are configured as a manifold. In particular, the upper end area and/or the lower end areas are configured such that they extend perpendicular to the plurality of channels.

The plurality of channels of the evaporator unit serves to transport the refrigerant from the lower end area to the upper end area of the evaporator unit. The refrigerant in the channels is heated. As a consequence of the heating, the refrigerant, especially its liquid parts, evaporates partially. The gaseous parts, i.e. the gas bubbles, coalesce into larger bubbles which eventually occupy the respective entire channel trapping liquid parts of the refrigerant in between them. Due to the bubbles rising, they take the trapped parts of liquid with them. This bubble pumping action serves to move the refrigerant from the lower end area of the evaporator unit to its upper end area.

The upper end area of the evaporator unit is connected to the lower end area by a first line which is configured to transfer only liquid from the upper end area to the lower end area. The term "liquid" used before refers to the liquid parts of the refrigerant which have previously be moved from the lower end area to the upper end area of the evaporator unit.

The first line is preferably configured as a tube connecting the upper end area to the lower end area. Preferably, the first line is arranged such that the transfer of liquid from the upper end area to the lower end area results due to gravity. The first line is preferably configured to be adiabatic. Advantageously, the walls of the first line are adiabatic so that liquid of the refrigerant does not boil, which could prevent it from returning to the lower end area of the evaporator. For example, the first line could be insulated to achieve this effect.

According to the invention, the upper end area is configured to let liquid and gas being transported to the upper end area by means of the plurality of channels of the evaporator unit separate from each other so that liquid can flow back to the lower end area by means of the first line. The separation is a result of gravity. The term "liquid" and "gas" refers to the liquid parts and gaseous parts of the two-phase refrigerant which have been transported by means of the channels to the upper end area. The liquid parts and the gaseous parts having arrived at the upper end area can thus from a continuous liquid phase and a continuous gas phase, so that the intermixed two-phase state does not exist anymore. The first line is arranged such that liquid from the continuous liquid phase can flow back to the lower end area of the evaporator unit.

In particular, the upper end area has a larger cross dimension than a cross dimensions of the channels so that in the upper end area there is no bubble pumping action and thus separation of the phases anymore.

The upper end area is preferably basin-shaped or trough-shaped. Preferably, the upper end area is configured as a sink. The upper end area has advantageously a bottom, in particular a bottom wall. In this bottom wall the second end areas of the channels are preferably disposed so that liquid parts from the refrigerant arriving at the upper end area can accumulate in the upper end area. In particular, the second ends of the channels are formed as an opening in the bottom wall. In particular, arriving at the upper end area the liquid parts form a continuous liquid phase. This liquid phase covers the bottom of the upper end area of the evaporator unit.

The first line is preferably configured as a drain which is further preferred disposed at the bottom especially the bottom wall, of the evaporator unit. The first line being configured as a drain lets only liquid travel from the upper end area to the lower end area. In particular, the first line is configured as a bubble pump liquid return line.

Preferably, the first line has a first end being disposed in the upper end area as well as a second end which can be disposed in the lower end area of the evaporator unit. The first end is preferably disposed at a lower side of the upper end area. In particularly, the first end is configured as an opening in the evaporator unit, especially in its bottom wall. Further, the first end of the first line can be configured as an opening in a side wall of the evaporator unit, especially in a region which is close to the bottom so that also a small accumulation of liquid can be drained by means of the first line.

As an effect of the present invention, the height of the liquid, in other words the liquid column height, within the evaporator unit is reduced. The liquid column height especially refers to the height of the liquid reaching the upper end area of the evaporator unit and accumulating there. In this upper end area, the separation of the liquid parts and gaseous parts of the refrigerant is not maintained so that the liquid parts form a continuous phase and the gaseous parts form a continuous phase. By means of the first line liquid from the continuous liquid phase is allowed to travel back to the lower end area which in turn reduces the accumulation of liquid in the upper end area and thus the liquid column height. As a consequence, the head pressure at the lower end area of the evaporator unit is substantially reduced. This effect allows the heat exchanging element to be driven with a smaller head pressure. Since the liquid column height can be smaller and still provide the necessary pressure to drive the heat exchanging element, the condenser unit can be lowered with respect to the evaporator unit without the risk of the condenser unit being flooded.

Therefore, the entire heat exchanger can be configured to the substantially smaller in a longitudinal direction of the heat exchanging element, since a substantial overlap between the condenser unit and the evaporator unit without the risk of the condenser unit being flooded can be allowed.

In arrangement known from prior art, the condenser unit and the evaporator unit have to be placed above each other with a condenser unit being entirely on top of the evaporator unit. However, due to the bubble pumping action of the present invention as well as the first line the condenser unit and the evaporator unit may overlap in vertical direction quiet considerably. As a result, the heat exchanging element, and thus also the entire heat exchanger, can be configured to be relevantly shorter in the vertical direction which allows the heat exchanger to be more compact.

According to the invention, the condenser unit has an upper end area, a lower end area and a plurality of channels, wherein the heat exchanging element has a second line for transporting gas from the upper end area of the evaporator unit to the upper end area of the condenser unit. By the term "gas" mentioned before the gas of the refrigerant is meant which has been transported from the lower end area to the upper end area of the evaporator unit. Having arrived at the upper end area of the evaporator unit the gaseous parts of the two-phase refrigerant form a continuous gas phase which travels by means of the second line to the upper end area of the condenser unit.

Preferably, the condenser unit is configured alike the evaporator unit described above. This applies especially to the configuration of the channels as well as the upper and lower end areas. However, the function of the plurality of channels is different when it comes to the condenser unit. The channels serve for transporting refrigerant, especially liquid, from the upper end area of the condenser unit to its lower end area. This transport is a result of gravity.

The second line is preferably configured as a tube, which has a first end being disposed at the upper end area of the evaporator unit and a second end being disposed at the upper end area of the condenser unit. The second line is preferably configured as a gas riser tube. The first end of the second line is preferably disposed such that the liquid accumulating in the upper end area cannot reach the first end of the second line. The first end of the second line is thus disposed considerably higher with regard to the first end of the first line. In particular, the first end is disposed in at the top of the upper end area of the evaporator unit so that the second line serves to only transport gas. The first end could be disposed in a top wall or a side wall of the evaporator unit, especially in a region which is close to the top.

All in all, the present heat exchanger has a phase management system which is characterized by a separation of the two-phases of the two-phase refrigerant after having traveled to the upper end area of the evaporator unit. While this phase management system by means of the first line and the second line reduces the liquid column height within the evaporator unit, it also reduces the liquid column height in the second line.

As a consequence, the heat exchanging element can be smaller than a unit of the same capacity known from prior art which does not use a phase management system. The heat exchanging element with a phase management system is able to be packaged with more specific cooling capacity per unit volume in comparison to heat exchanging elements without such a system. This allows the heat exchanging element, and thus also the heat exchanger, to be shorter in the vertical direction since an overlap of the condenser unit in the evaporator unit does not risk any flooding of the condenser unit.

In particular, the heat exchanging element has a third line for transporting liquid from the lower end area of the condenser unit to the lower end area of the evaporator unit. This third line is also preferably configured as a tube, especially a liquid refrigerant return line. By the term "liquid" used before the liquid which has travelled from the upper end area of the condenser unit to the lower end area of the condenser unit is meant. The third line has a first end being disposed in the lower end area of the condenser unit as well as a second area being disposed in the lower end area of the evaporator unit. The second end of the first line can also mouth in the third line though which liquid also arrives at the lower end area of the evaporator unit.

The reduced liquid column height in the second line allows the heat exchanging element to circulate refrigerant with a lower liquid head pressure in the third line. Because of this, a shorter liquid column is required within the third line so that is substantial overlap between the condenser unit and the evaporator unit in a vertical direction can be achieved. This effect allows the heat exchanging element to be driven with a smaller head pressure resulting from the reduced liquid column height in the third line.

According to the invention, the heat exchanging element is configured as a thermosiphon. In particularly, the heat exchanger is configured as a two-phase thermosiphon air-to-air heat exchanger.

Further preferred, the heat exchanging element, in particular, the evaporator unit and/or the condenser unit, have an extruded metallic material. Preferably, the heat exchanging element, in particular the evaporator unit and/or the condenser unit, are formed from the extruded metallic material. The metallic material is preferably aluminum. In particular, the evaporator unit and/or the condenser unit are configured as a brazed aluminum micro-channel heat exchanger. The heat exchanging element particularly does not comprise copper.

Advantageously, the entire functional portion of the heat exchanging element is made of one metallic material. With the heat exchanging element being made of only one metal, it is more corrosion resistant than a traditional heat exchanging element comprising more than one metal, wherein due to this bi-metal configuration galvanic corrosion could result. The heat exchanging element can further be electromechanically plated or coated in a metal or metal rich compound, said metal or metal rich compound acting as a sacrificial anode and thus providing cathodic protection to the functional portion of the heat exchanging element. The above-mentioned metal for this protection is preferably Zinc. The term "functional portion" of the heat exchanger especially refers to the entire heat exchanger except for a possible coating.

The condenser side and the evaporator side are preferably separated from each other by a barrier. Advantageously, the condenser side and the evaporator side are completely separated by the barrier.

The heat exchanger is especially configured for electronic enclosure cooling scenarios in which the ambient air of the enclosures is contaminated by dust, liquid, gases, etc. The barrier prevents ingress of contaminates, especially from an outside of the electronic enclosure, into the inside of the electronic enclosure. Preferably, the barrier is formed by a solid plate, especially a metal plate, in particular made from aluminum. The solid plate could also be made from plastic. The barrier can advantageously be formed by an inner wall of the casing of the heat exchanger.

The heat exchanging element has a longitudinal direction. In particular, the evaporator unit has a longitudinal direction, while the evaporator unit has a longitudinal direction which are most preferred are aligned and parallel to the longitudinal direction of the heat exchanging element.

The heat exchanger advantageously comprises an evaporator fan for producing a first air stream on the evaporator side and a condenser fan for producing a second air stream on the evaporator side, wherein the barrier is configured to separate the first air stream and the second air stream. In particular, the barrier is configured as an air side barrier for completely separating the first air stream on the evaporator side and the second air stream on the condenser side. For this purpose, the barrier can be air tight.

Especially, the evaporator fan is disposed on the evaporator side, wherein the condenser fan is disposed on the condenser side of the heat exchanger. The evaporator fan and/or the condenser fan are preferably disposed in an inside of the heat exchanger. The condenser fan is preferably configured to draw in cool ambient air from an outside of the heat exchanger into an inside of the heat exchanger especially on the condenser side. The condenser fan is disposed such within the heat exchanger that it lets out hot air to an outside of the heat exchanger. On the other hand, the evaporator fan is disposed such that it draws in hot air from the electronic enclosure. The drawn-in cool ambient air travels through the condenser side and forms the second air stream, while the drawn-in hot air from the electronic enclosure travels through the evaporator side and forms the first air stream.

The condenser fan and the evaporator fan are preferably arranged such that the first air stream and a second air stream both penetrate the heat exchanging element, preferably substantially perpendicular through the longitudinal direction of the heat exchanging element. Especially, the evaporator fan is disposed such that the first air stream travels through the evaporator unit of the heat exchanging element, while the condenser fan is disposed such that the second air stream travels through the condenser unit.

For producing the first and/or the second air stream the casing preferably has two openings on the evaporator side and the condenser side, respectively.

On the condenser side the casing of the heat exchanger preferably comprises a first opening for letting cool ambient air from an outside of the heat exchanger enter the inside of the heat exchanger. The cool ambient air is drawn in through the first opening on the condenser side by means of the condenser fan. The condenser fan is particularly arranged such that after entering the inside through the first opening the cool ambient air passes through the condenser unit towards the condenser fan. The casing further preferred has a second opening for letting hot air exit the inside of the heat exchanger at its condenser side to the outside. By "hot air" the ambient air which is heated by means of passing through the condenser unit is meant. The cool ambient air passing through the condenser unit and exiting by the second opening to the outside of the heat exchanger in form of hot, i.e. heated, air forms the second air stream. In particular, the condenser fan is disposed at and/or in the second opening of the casing. Alternatively, the condenser fan can draw in cool ambient air through the second opening, while the first opening then serves as an exit for the heated air. Especially, the condenser fan can reverse its direction of rotation and is thus configured to pull air through the condenser unit or push air through it.

On the evaporator side the casing of the heat exchanger particularly comprises a third opening for letting hot air from an inside of the electronic enclosure enter the inside of the heat exchanger. For this purpose, also the casing of the electronic enclosure can have an opening which is aligned to the third opening. The hot air is drawn in from the electronic enclosure to an inside of the heat exchanger by means of the evaporator fan which is further preferred disposed at and/or in the third opening.

The evaporator fan is particularly arranged such that the drawn in hot air passes through the evaporator unit and returns back through a fourth opening in the casing in form of cool air, i.e. cooled by means of passing through the evaporator unit, air to the inside of the electronic enclosure. The hot air from the electronic enclosure travelling through the evaporator unit and returning to the electronic enclosure forms the first air stream being produced by the evaporator fan. The evaporator unit is preferably arranged at and/or in the fourth opening.

The third and the fourth opening are advantageously arranged such that after passing the evaporator unit and before returning to the inside of the electronic enclosure the first air stream is deflected on an inner wall, such as e.g. the barrier, of the casing. Alternatively, the evaporator fan can draw in cool ambient air through the fourth opening, while the third opening then serves as an exit for the cooled air. Especially, the evaporator fan can reverse its direction of rotation and is thus configured to pull air through the evaporator unit or push air through it.

The heat exchanger prevents ingress of contaminates into electrical enclosures more completely than known air-to-air heat exchangers. This is accomplished by the condenser side and the evaporator side being completely separated by the barrier. The only passages between the two sides are just large enough to allow for the second line and the third line which can easily be sealed.

A heat exchanger with a phase management system as described before is able to operate with a low ΔT between the first air stream and the second air stream. While a traditional heat exchanger may need a ΔT of 7°C to initiate refrigerant flow, the present heat exchanger with a phase management system may only need a ΔT of 5°C, preferably of only 3°C.

The heat exchanger according to the invention is smaller and more cost effective when compared to state of the art heat exchangers. Furthermore, the heat exchanger according to the invention can be configured to have a similar functionality as known heat exchangers but have a smaller physical volume per specific cooling capacity of the unit. The heat exchanger is thus more compact.

Advantageously, a cross dimension of the channels, preferably a diameter, is small enough so that the surface tension of the liquid parts of the refrigerant is able to prevent the gaseous parts of the refrigerant from passing them towards the upper end area of the evaporator unit. By this, the gaseous parts moving towards the condenser side take the liquid parts with them. Furthermore, it is advantageous to have a possibly large cross dimension of the channels for the following two reasons: flow restrictions within the channels should be reduced, while at the same time the mass flow rate of the refrigerant should be increased. Since there are reasons for increasing the cross dimension and reasons for reducing it, a desirable compromise has been found by preferably configuring the channels such that a cross dimension is between 0,1 mm and 12 mm, preferably between 0,2 mm and 10 mm, further preferred between 0,4 mm and 6 mm, most preferred between 2 mm and 5 mm.

The feature of the cross dimension is most critical for the channels within the evaporator unit as it facilitates the bubble pumping action that carries refrigerant to the upper end area of the evaporator unit. This ensures that the channels of the evaporator unit are continuously wetted by refrigerant.

The term "cross dimension" means a dimension in cross direction to the longitudinal direction of the channels and/or the heat exchanging element, especially a longitudinal direction of the evaporator unit and/or a longitudinal direction of a condenser unit. In particular, the channels have an oval shape. Most preferred the channels have a round shape so that the cross dimension refers to the diameter of the channels. In particular, the channels are formed during the extrusion of the respective mini-channel as ports of the mini-channel.

In particular, there can be check-valves incorporated into the refrigerant flow which favor the gaseous movement towards the condenser unit of the heat exchanger as well as the mostly liquid return to the evaporator unit.

Furthermore, the heat exchanger can comprise metal plates which are disposed between neighboring channels, especially between neighboring channels of different mini-channels. Especially, the metal plates are disposed between neighboring mini-channels. The metal plates are preferably configured as fins, especially pleated fins. The fins are advantageously made of aluminum. The metal plates are preferably brazed between the channels to help the heat transfer between the air on the condenser side and/or the evaporator side and the refrigerant within the channels by means of conduction. Apart from facilitating the heat transfer, the metal plates provide stability to the heat exchanging element. Especially, the metal plates are arranged such that there are counts of 4 metal plates per inch to 40 metal plates per inch, optimally 12 metal plates per inch to 25 metal plates per inch. The metal plates are particularly arranged in a V-shaped or U-shaped configuration. The metal plates can further be arranged louvered or not louvered.

Advantageously, metal plates are arranged at an angle towards the direction in which the channels are extending, especially the longitudinal direction of the heat exchanger, wherein the angle preferably is between 0° and 90°, more preferred between 60° and 89,9°, even more preferred between 70° and 89,7°, most preferred between 80° and 89,5°. An angle between neighboring metal plates can be between 0° and 180°, more preferred between 0° and 90°, even more preferred between 0° and 45°, most preferred between 0° and 10°. An angle between neighboring metal plates can be between 0° and 180°, more preferred between 0° and 90°, even more preferred between 0° and 45°, most preferred between 0° and 10°.

The metal plates can have a constant thickness, wherein the thickness is advantageously between 0,01 mm to 5 mm, more preferred between 0,025 mm and 2,3 mm, even more preferred between 0,05 mm and 1 mm, most preferred between 0,07 mm and 0,4 mm.

In particularly, the condenser unit is configured larger than the evaporator unit. Therefore, the condenser unit can be larger in its dimension, especially regarding its dimension in longitudinal direction, i.e. its length. The length of the condenser unit is preferably at least 1,2 times, most preferred at least 1,5 times, larger than the length of the evaporator unit. The larger configuration is beneficial since it ensures a full condensation of the two-phase refrigerant on the condenser side.

Furthermore, an aspect of the invention relates to the use of a heat exchanger, as described above, for cooling an electronic enclosure.

### Brief description of the drawings

The above-mentioned and the other features of the invention disclosed herein are described below with reference to the drawings of the preferred embodiments. The illustrated embodiments are intended to illustrate, but not to limit the inventions. The drawings contain the following figures:
- Figure 1: a longitudinal sectional view of a heat exchanger according to the invention being attached to an electronic enclosure;
- Figure 2: a longitudinal sectional view of the evaporator unit and the condenser unit of the heat exchanger according to figure 1;
- Figure 3: a cross sectional view along the line A-A of figure 2;
- Figure 4: a schematic view of the refrigerant flow between the evaporator unit and the condenser unit; and
- Figure 5: an enlarged cross sectional view of a mini-channel.

### Detailed Description of the preferred embodiments

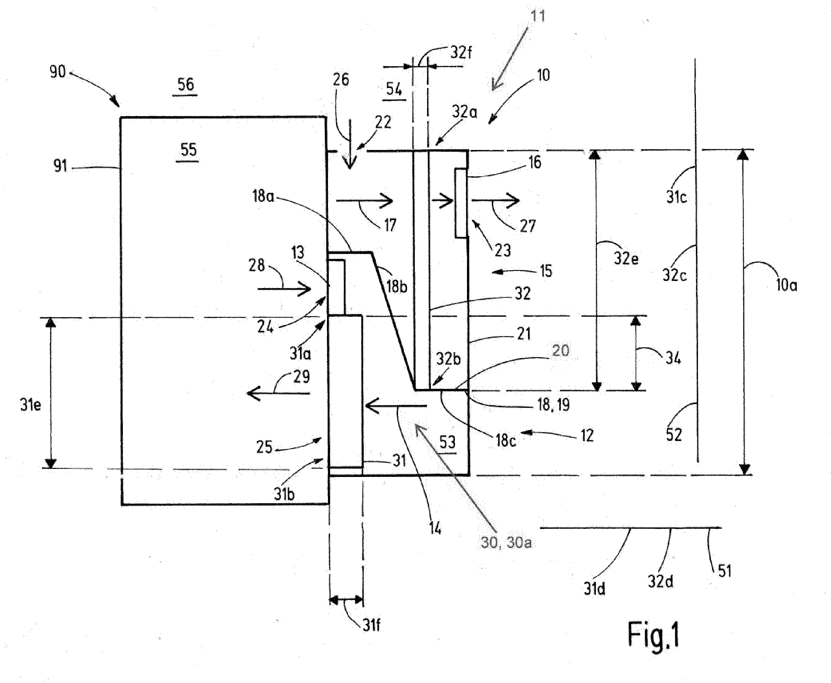

Figure 1 shows a longitudinal sectional view of a heat exchanger (10) which is configured as an air-to-air heat exchanger (11). The heat exchanger (10) is attached to an electronic enclosure (90). For this purpose, the heat exchanger (10) comprises a casing (21) which is attached to the respective casing (91) of the electronic enclosure (90). The casing (91) defines an inside (55) and an outside (56) of the electronic enclosure (90).

The heat exchanger (10) comprises a condenser side (15) and an evaporator side (12). The condenser side (15) of the heat exchanger (10) is located higher than the evaporator side (12). The condenser side (15) is separated from the evaporator side (15) by a barrier (18) which is configured as a metal plate (19), namely an inner wall (20) in the casing (21).The condenser side (15) and the evaporator side (12) are both disposed in the inside (53) of the heat exchanger (10). The heat exchanger (10) comprises on its evaporator side (12) an evaporator fan (13) configured to produce a first air stream (14). Furthermore, the heat exchanger (10) has a condenser fan (16) on the condenser side (15) configured to produce a second air stream (17). The barrier (18) is configured to separate the first air stream (14) and the second air stream (17).

The heat exchanger (10) comprises a heat exchanging element (30) which is configured as a thermosiphon (30a). The heat exchanging element (30) comprises an evaporator unit (31) as well as a condenser unit (32). The evaporator unit (31) is disposed on the evaporator side (12) of the heat exchanger (10), while the condenser unit (32) is disposed on the condenser side (15). The evaporator unit (31) has an upper end area (31a) and a lower end area (31b). Also, the condenser unit (32) has an upper end area (32a) and a lower end area (32b).

The evaporator unit (31) has a longitudinal direction (31c) and a cross direction (31d) as well as a length (31e) in the longitudinal direction (31c) and a width (31f) in the cross direction (31d). The condenser unit (32) also has a length (32e) in a longitudinal direction (32d) as well as the width (32f) in a cross direction (32d). The longitudinal direction (31c) of the evaporator unit (31) corresponds to the longitudinal direction (32c) of the condenser unit (32). The same applies to the cross directions (31d, 32d). Furthermore, the longitudinal directions (31c, 32c) correspond to the vertical direction (52), whereas the cross directions (31d, 32d) correspond to the horizontal direction (51).

In vertical direction (52) the evaporator unit (31) and the condenser unit (32) overlap with each other by an overlap (34). Thus, the length (10a) of the heat exchanger is smaller than the sum of the lengths (32e, 31e) of the condenser unit (32) and the evaporator unit (31).

Due to the overlap (34), the barrier (18) has one part (namely the second part (18b)) which has an angle to the vertical direction (52). The second part (18b) is formed oblique. Furthermore, the barrier has a first part (18a) and a third part (18c) extending in the horizontal direction (51). The second part (18b) is disposed between the first part (18a) and the third part (18c). Each part (18a, 18b, 18c) amounts to about one third of the entire length of the barrier (18) projected on the horizontal direction (51).

The heat exchanging element (30), in particular the evaporator unit (31) and the condenser unit (32), comprises an extruded metallic material (35) which is aluminum (36). The connections for fluid transfer between the evaporator unit (31) and the condenser unit (32) penetrating the barrier (18) are not shown in figure 1.

On the condenser side (15) the casing (21) of the heat exchanger (10) comprises a first opening (22) for letting cool ambient air (26) from an outside (54) of the heat exchanger (10) enter the inside (53) of the heat exchanger. The cool ambient air (26) is drawn in through the first opening (22) on the condenser side by means of the condenser fan (16). The cool ambient air (26) enters the inside (53) through the first opening (22) and passes through the condenser unit (32) towards the condenser fan (16).

At the location of the condenser fan (16) the casing (21) of the heat exchanger (10) comprises a second opening (23) for letting hot air (27) exit the inside (53) of the heat exchanger (10) at its condenser side (15) to the outside (54). By "hot air" the ambient air which is heated by means of passing through the condenser unit (32) is meant. The cool ambient air (26) passing through the condenser unit (32) and exiting by the second opening (23) to the outside (54) of the heat exchanger (10) in form of hot, i.e. heated, air (27) forms the second air stream (17).

On the evaporator side (12) the casing (21) of the heat exchanger comprises a third opening (24) for letting hot air (28) from an inside (55) of the electronic enclosure (90) enter the inside (53) of the heat exchanger (10). The hot air (28) is drawn in from the electronic enclosure (90) to an inside (53) of the heat exchanger (10) by means of the evaporator fan (13) which is disposed at the third opening (24). The drawn in hot air (28) passes through the evaporator unit (31) and returns back through a fourth opening (25) in the casing (21) in form of cool air (29), i.e. cooled by means of passing through the evaporator unit (31), air to the inside (55) of the electronic enclosure (90). The evaporator unit (31) is disposed in the fourth opening (25). The hot air (28) from the electronic enclosure (90) travelling through the evaporator unit (31) and returning to the electronic enclosure (90) in form of cool air (29) forms the first air stream (14) which is produced by the evaporator fan (13). After passing the evaporator fan (13) and before returning to the inside (55) of the electronic enclosure (90) the first air stream (14) is deflected on an inner wall of the casing (21), in particular the barrier (18), most preferred its second part (18b).

All in all, for allowing the first air stream (14) and the second air stream (17) the casing (21) of the heat exchanger (10) comprises two openings respectively on the evaporator side (12) and the condenser side (15).

The first air stream (14) and the second air stream (17) can be reversed in their respective flow direction. To reverse the flow direction, the rotational direction of the evaporator fan (13) as well as the condenser fan (16) can be reversed. In detail, the condenser fan (16) draws in cool ambient air (26) through the second opening (23) at which the condenser fan (16) is disposed. The cool ambient air (26) enters the inside (53) of the heat exchanger (10) at its condenser side (15), passes through the condenser unit (32) and exits to the outside (54) of the heat exchanger (10) by means of the first opening (22) within the casing (21) in the form of hot, i.e. heated, air (27).

On the evaporator side (12) hot air (28) from the inside (55) of the electronic enclosure (90) enters the inside (53) of the heat exchanger (10) by means of the fourth opening (25), travels through the evaporator unit (31) and exits the inside (53) of the heat exchanger (10) to the inside (55) of the electronic enclosure (90) through the third opening (24) in the form of cool, i.e. cooled, air. At the third opening (24) the evaporator fan (13) is disposed.

The condenser fan (16) is therefore able to either push air through the condenser unit (32) or pull air through it. The same applies to the evaporator fan (13) with regard to the evaporator unit (31).

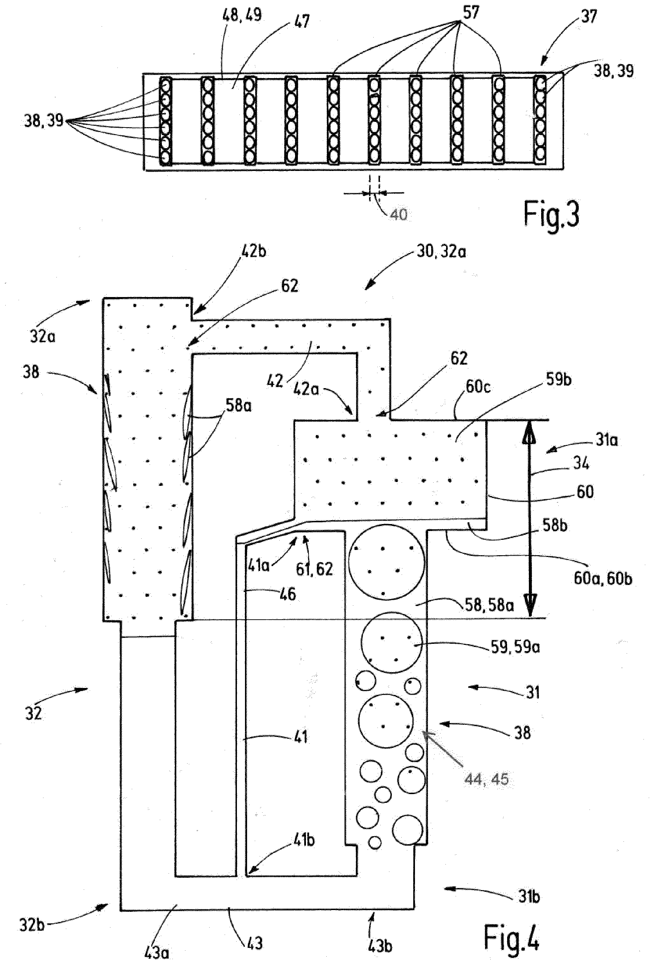

The two-phase refrigerant (45) is present within the channels (38) in a gaseous state, thus gas (59), and a liquid state, thus liquid (58) (see also figure 4). This means that the channels (38) are filled with liquid parts (58a) and gaseous parts (59a) of the two-phase refrigerant (45) which do not form a continuous phase respectively. Rather, the liquid parts (58a) and gaseous parts (59a) are intermixed. The gaseous parts (59a) are formed by gas bubbles, while the liquid parts (58a) are formed by drops or larger accumulations of liquid (58).

In the evaporator unit (31) the refrigerant (44) is heated by means of the first air stream (14). As a consequence of the heating, the refrigerant (44), especially its liquid parts (58a), evaporates partially. The gaseous parts (59a), i.e. the gas bubbles, coalesce into larger bubbles which eventually occupy the respective entire channel (38) trapping liquid parts (59a) of the refrigerant (44) in between them. Due to the bubbles rising, they take the trapped parts of liquid (58) with them. This bubble pumping action serves to move the refrigerant (44) from the lower end area (31b) to the upper end area (31a) of the evaporator unit (31) (see also figure 4).

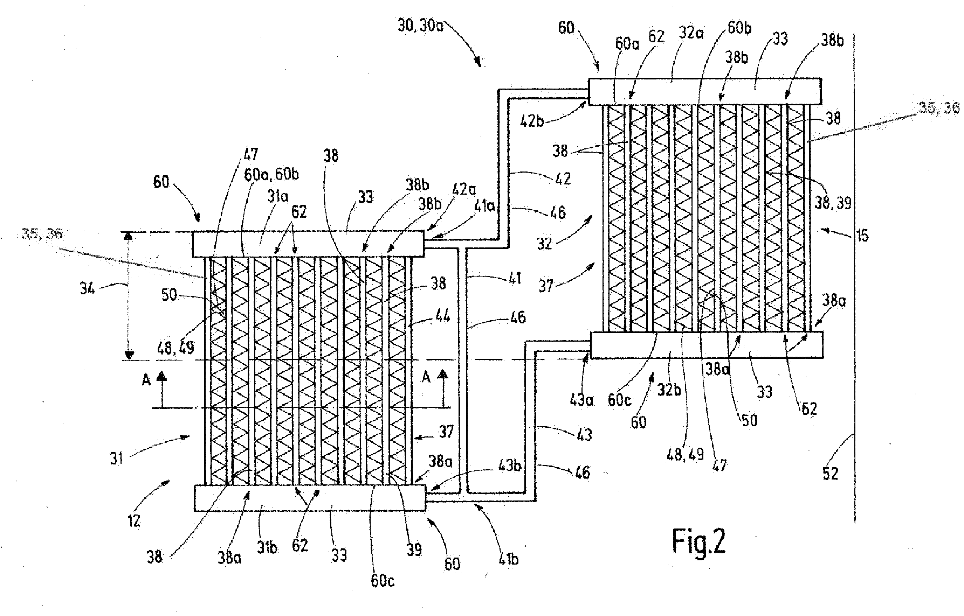

In Figure 2 the evaporator unit (31) and a condenser unit (32) of the heat exchanging element (30) is shown. In particular, the thermosiphon (30a) is shown.

The upper end area (31a) and the lower end area (31b) of the evaporator unit (31) are both designed as manifolds (33). The same applies to the condenser unit (32), in particular its upper end area (32a) and its lower end area (32b). The evaporator unit (31) and the condenser unit (32) overlap in vertical direction (52) by the overlap (34) since the upper end area (31a) of the evaporator unit (31) is located higher than the lower end area (32b) of the condenser unit (32).

The evaporator unit (31) and the condenser unit (32) have a plurality (37) of channels (38) which are formed as micro-channels (39). The channels (38) of the evaporator unit (31) have a first end (38a) disposed in the lower end area (31b) as well as a second end (38b) disposed in the upper end area (31a). In particular, the second ends (38b) of the channels (38) are disposed as openings (62) in a bottom (60a) of the upper end area (31a) which is formed as a basin (60). In particular, the upper end area (31a) comprises a bottom wall (60b) to which the channels (38) lead. The second ends (38b) of the channels (38) are thus formed as openings (62) in the bottom wall (60b) of the upper end area (31a). Furthermore, the first end areas (38a) of the channels (38) are formed as openings (62) in a top wall (60c) of the lower end area (31b) of the evaporator unit (31).

Also the condenser unit (32) comprises a plurality (37) of channels (38) with a first end (38a) and a second end (38b) which are designed in the same way as described above for the evaporator unit (31).

The liquid parts (58a) and the gaseous parts (59a) of the refrigerant (44) arriving in the upper end area (31a) of the evaporator unit (31a) are allowed to separate by gravity and form respective continuous phases (58b, 59b), namely a continuous liquid phase (58b) covering the bottom wall (60b) of the upper end area (31a) and a continuous gas phase (59b) (see also figure 4).

The liquid (58), namely the continuous liquid phase (58b), travels through a first line (41) of the heat exchanging element (30). The first line (41) is configured as a tube (46). The first line has a first end (41a) disposed in the upper end area (31a) of the evaporator unit (31) and a second end (41b) disposed in the lower end area (31b) of the evaporator unit (31) (see also figure 4).

The first line (41) is configured as a drain (61) of the upper end area (31a). The first end (41a) is particularly designed as an opening (62) in a side wall (60d) of the upper end area (31a) being in close proximity to the bottom (60a). While liquid (58), namely liquid from the continuous liquid phase (58b), is allowed to flow back to the lower end area (31b) of the evaporator unit (31), gas (59) which has travelled to the upper end area (31a), namely gas from the continuous gas phase (59b), travels to the upper end area (32a) of the condenser unit (32) by means of a second line (42) of the heat exchanging element (30) being configured as a tube (46). The second line (42) has a first end (42a) being disposed in the upper end area (31a) of the evaporator unit (31) and a second end (42b).

The gas (59) arriving in the upper end area (32a) of the condenser unit (32) is cooled by means of the second air stream (17). After having cooled down the gaseous parts (59a) of the refrigerant (44) condense again and the refrigerant (44) travels back to the lower end area (32b) of the evaporator unit (32) by means of the channels (38) of the condenser unit.

For returning accumulated liquid (58) from the lower end area (32b) to the lower end area (31b) of the evaporator unit the heat exchanging element (30) comprises a third line (43) configured as a tube (46) extending from the lower end area (32b) of the condenser unit (32) to the lower end area (31b) of the evaporator unit (31). Therefore, the third line (43) has a first end (43a) being disposed in the lower end area (32b) of the condenser unit (32) and a second end (43b) disposed in the lower end area (31b) of the evaporator unit (31). The second end (41b) of the first line (41) mouths in the third line (43).

Between neighboring channels (38) metal plates (47) in the form of fins (48), namely pleated aluminum fins (49), are disposed. The metal plates (47) facilitate the heat transfer between the air streams (14, 17) and the refrigerant (44) within the channels (38) via conduction. The metal plates (47) form an angle (50) towards the direction in which the channels (38) extend, especially to the vertical direction (52). The pleated aluminum fins (49) are arranged in a V-shaped configuration between the neighboring channels (38).

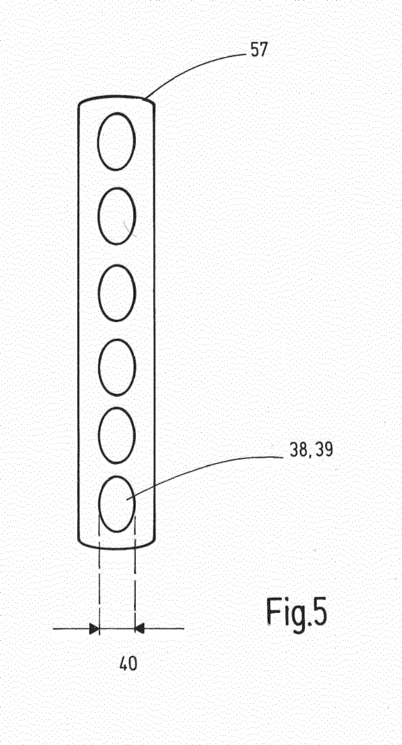

Figure 3 shows a cross sectional view along the line A-A of figure 2. The channels (38) have a cross dimension (40) and a substantially oval shape. The channels (38) are formed as ports of mini-channels (57) which are substantially rectangular-shaped. In particular, six channels (38) form the ports of one mini-channel (57), wherein the evaporator unit (31) comprises ten mini-channels (57) (see figure 5). In between the mini-channels (57) the metal plates (47) in the form of pleated aluminum fins (49) are disposed.

In figure 4 a schematic overview of the flow of the refrigerant (44) between the evaporator unit (31) and the condenser unit (32) of the heat exchanging element (30) is shown.

Of the evaporator unit (31) an over-dimensioned channel (38) is exemplarily shown. Within the channel (38) the two-phase refrigerant (45) is present, namely liquid (58) in the form of liquid parts (58a) and gas (59) in the form of gaseous parts (59a). Due to the heating, liquid parts (58a) evaporate so that larger gaseous parts (59a) in the form of bubbles are formed. All in all, the refrigerant (44) travels from the lower end area (31b) to the upper end area (31a) of the evaporator unit (31) through the channels (38) via the bubble pumping action.

Due to the much larger dimensions, namely cross dimensions of the upper end area (31a), compared to the cross dimensions of the channels (38), the gaseous parts (59a) and the liquid parts (58a) are allowed to separate and form a continuous liquid phase (58b) and a continuous gas phase (59b). The continuous liquid phase (58b) covers the bottom (60a) of the upper end area (31a). The first end (41a) of the first line (41) forms an opening (62) in the side wall of the upper end area (31a) so that liquid (58) from the continuous liquid phase (58b) can flow back to the lower end area (31b). The second end (41b) of the first line (41) ends in the third line (43) of the heat exchanging element (30) from where the liquid (58) flows back to the lower end area (31b).

The continuous gas phase (59b) in the upper end area (31a) travels by means of the second line (42) to the upper end area (32a) of the condenser unit (32). Exemplarily, an over-dimensioned channel (38) of the condenser unit (32) is shown. Liquid parts (58a) are formed by condensation and due to gravity travel to the lower end area (32b) of the condenser unit (32). From there, the liquid (58) is transported to the lower end area (31b) of the evaporator unit (31) by means of the third line (43).

Figure 5 shows an enlarged cross sectional view of a mini-channel (57) of the heat exchanger (10). The mini-channel (57) has a substantially rectangular shape, while the channels (38) have are substantially oval-shaped. The channels (38) are formed as ports of the mini-channel (57).

### List of reference signs

- 10: heat exchanger
- 10a: length of heat exchanger
- 11: air-to-air heat exchanger
- 12: evaporator side
- 13: evaporator fan
- 14: first air stream
- 15: condenser side
- 16: condenser fan
- 17: second air stream
- 18: barrier
- 18a: first part
- 18b: second part
- 18c: third part
- 19: metal plate
- 20: wall
- 21: casing of heat exchanger
- 22: first opening
- 23: second opening
- 24: third opening
- 25: fourth opening
- 26: cool ambient air
- 27: hot air exiting inside of heat exchanger
- 28: hot air from the electronic enclosure
- 29: cool air to return to electronic enclosure
- 30: heat exchanging element
- 30a: thermosiphon
- 31: evaporator unit
- 31a: upper end area of evaporator unit
- 31b: lower end area of evaporator unit
- 31c: longitudinal direction of evaporator unit
- 31d: cross direction of evaporator unit
- 31e: length of evaporator unit
- 31f: width of evaporator unit
- 32: condenser unit
- 32a: upper end area of condenser unit
- 32b: lower end area of condenser unit
- 32c: longitudinal direction of condenser unit
- 32d: cross direction of condenser unit
- 32e: length of evaporator unit
- 32f: width of evaporator unit
- 33: manifold
- 34: overlap
- 35: extruded metallic material
- 36: aluminum
- 37: plurality of channels
- 38: channels
- 38a: first end
- 38b: second end
- 39: micro-channels
- 40: cross dimension
- 41: first line
- 41a: first end of first line
- 41b: second end of first line
- 42: second line
- 42a: first end of second line
- 42b: second end of second line
- 43: third line
- 43a: first end of third line
- 43b: second end of third line
- 44: refrigerant
- 45: two-phase refrigerant
- 46: tube
- 47: metal plates
- 48: fins
- 49: pleated aluminum fins
- 50: angle
- 51: horizontal direction
- 52: vertical direction
- 53: inside of heat exchanger
- 54: outside of heat exchanger
- 55: inside of electronic enclosure
- 56: outside of electronic enclosure
- 57: mini-channel
- 58: liquid
- 58a: liquid parts
- 58b: continuous liquid phase
- 59: gas
- 59a: gaseous parts
- 59b: continuous gas phase
- 60: basin
- 60a: bottom
- 60b: bottom wall
- 60c: top wall
- 60d: side wall
- 61: drain
- 62: opening
- 90: electronic enclosure
- 91: casing

## Claims

1. A heat exchanger (10) for cooling an electronic enclosure (90), comprising a condenser side (15) and an evaporator side (12),
wherein the heat exchanger (10) comprises a heat exchanging element (30) having a condenser unit (32) and an evaporator unit (31),
wherein the evaporator unit (31) comprises an upper end area (31a), a lower end area (31b) and a plurality (37) of channels (38) for transporting a refrigerant (44) from the lower end area (31b) to the upper end area (31a), said refrigerant (44) comprising liquid (58) and gas (59),
wherein
the heat exchanging element (30) is a thermosiphon (30a),
wherein the condenser unit (32) and the evaporator unit (31) are arranged such that the condenser unit (32) and the evaporator unit (31) overlap vertically, and wherein the condenser unit (32) has an upper end area (32a), a lower end area (32b) and a plurality (37) of channels (38), wherein the heat exchanging element (30) has a second line (42) for transporting gas (59) from the upper end area (31a) of the evaporator unit (31) to the upper end area (32a) of the condenser unit (32) **characterized in that**
the upper end area (31a) of the evaporator unit (31) is connected to the lower end area (31b) of the evaporator unit (31) by a first line (41), said first line (41) being configured to transfer only liquid (58) form the upper end area (31a) to the lower end area (31b) and **in that** the upper end area (31a) of the evaporator unit (31) is configured to let liquid (58) and gas (59) being transported to said upper end area (31a) by means of the plurality of channels (38) separate from each other to form a continuous liquid phase (58b) and a continuous gas phase (59b) so that liquid (58) can flow back to the lower end area (31b) of the evaporator unit (31) by means of the first line (41).

2. The heat exchanger (10) according to claim 1,
wherein the upper end area (31a) of the evaporator unit (31) is configured basin-shaped, wherein the first line (41) is configured as a drain (61).

3. The heat exchanger (10) according to any one of the previous claims,
wherein the condenser side (15) is located higher than the evaporator side (12).

4. The heat exchanger (10) according to claim 1,
wherein the heat exchanging element (30) has a third line (43) for transporting liquid (58) from the lower end area (32b) of the condenser unit (32) to the lower end area (31b) of the evaporator unit (31).

5. The heat exchanger (10) according to any one of the previous claims,
wherein the condenser side (15) and the evaporator side (12) are separated from each other by a barrier (18).

6. The heat exchanger (10) according to any one of the previous claims,
wherein the heat exchanger (10) comprises an evaporator fan (13) configured to produce a first air stream (14) on the evaporator side (12) and a condenser fan (16) configured to produce a second air stream (17) on the condenser side (15), wherein the barrier (18) is configured to separate the first air stream (14) and the second air stream (17).

7. The heat exchanger (10) according to any one of the previous claim,
wherein the channels (38) have a cross dimension (40) of 0,1 mm to 12 mm, preferably 0,2 mm to 10 mm, further preferred 0,4 mm to 6 mm, most preferred 2 mm to 5 mm.

8. The heat exchanger (10) according to any one of the previous claim,
wherein the channels (38) are partially filled with a refrigerant (44).

9. The heat exchanger (10) according to any one of the previous claim,
wherein the heat exchanger (10) comprises metal plates (47) being disposed between neighboring channels (38).

10. The heat exchanger (10) according to any one of the previous claims,
wherein the condenser unit (32) is configured larger than the evaporator unit (31).

11. A use of a heat exchanger (10) according to claims 1 to 10 for cooling an electronic enclosure (90).

## Patentansprüche

1. Wärmetauscher (10) zum Kühlen eines Elektronikgehäuses (90),
umfassend eine Kondensatorseite (15) und eine Verdampferseite (12),
wobei der Wärmetauscher (10) ein Wärmetauscherelement (30) aufweisend eine Kondensatoreinheit (32) und eine Verdampfereinheit (31) umfasst,
wobei die Verdampfereinheit (31) einen oberen Endbereich (31a), einen unteren Endbereich (31b) und eine Vielzahl (37) von Kanälen (38) zum Transportieren eines Kältemittels (44) vom unteren Endbereich (31b) zum oberen Endbereich (31a) umfasst, wobei das Kühlmittel (44) Flüssigkeit (58) und Gas (59) umfasst,
wobei das Wärmetauscherelement (30) ein Thermosiphon (30a) ist,
wobei die Kondensatoreinheit (32) und die Verdampfereinheit (31) so angeordnet sind, dass sich die Kondensatoreinheit (32) und die Verdampfereinheit (31) vertikal überlappen,
und wobei die Kondensatoreinheit (32) einen oberen Endbereich (32a), einen unteren Endbereich (32b) und eine Vielzahl (37) von Kanälen (38) aufweist, wobei das Wärmetauschelement (30) eine zweite Leitung (42) zum Transportieren von Gas (59) vom oberen Endbereich (31a) der Verdampfereinheit (31) zum oberen Endbereich (32a) der Kondensatoreinheit (32) aufweist, **dadurch gekennzeichnet, dass**
der obere Endbereich (31a) der Verdampfereinheit (31) mit dem unteren Endbereich (31b) der Verdampfereinheit (31) durch eine erste Leitung (41) verbunden ist, wobei die erste Leitung (41) so ausgestaltet ist, dass sie nur Flüssigkeit (58) vom oberen Endbereich (31a) zum unteren Endbereich (31b) überträgt, und dass
der obere Endbereich (31a) der Verdampfereinheit (31) so ausgestaltet ist, dass Flüssigkeit (58) und Gas (59), die mittels der Mehrzahl von voneinander getrennten Kanälen (38) zum oberen Endbereich (31a) transportiert werden, um eine kontinuierliche Flüssigphase (58b) und eine kontinuierliche Gasphase (59b) zu bilden, so dass Flüssigkeit (58) mittels der ersten Leitung (41) zum unteren Endbereich (31b) der Verdampfereinheit (31) zurückfließen kann.

2. Wärmetauscher (10) gemäß Anspruch 1,
wobei der obere Endbereich (31a) der Verdampfereinheit (31) beckenförmig ausgestaltet ist, wobei die erste Leitung (41) als Abfluss (61) ausgestaltet ist.

3. Wärmetauscher (10) gemäß einem der vorhergehenden Ansprüche,
wobei die Kondensatorseite (15) höher als die Verdampferseite (12) angeordnet ist.

4. Wärmetauscher (10) gemäß Anspruch 1,
wobei das Wärmetauscherelement (30) eine dritte Leitung (43) zum Transportieren von Flüssigkeit (58) vom unteren Endbereich (32b) der Kondensatoreinheit (32) zum unteren Endbereich (31b) der Verdampfereinheit (31) aufweist.

5. Wärmetauscher (10) gemäß einem der vorhergehenden Ansprüche, wobei die Kondensatorseite (15) und die Verdampferseite (12) durch eine Barriere (18) voneinander getrennt sind.

6. Wärmetauscher (10) gemäß einem der vorhergehenden Ansprüche,
wobei der Wärmetauscher (10) ein Verdampfergebläse (13), das so ausgestaltet ist, dass es einen ersten Luftstrom (14) auf der Verdampferseite (12) erzeugt, und ein Kondensatorgebläse (16), das so ausgestaltet ist, dass es einen zweiten Luftstrom (17) auf der Kondensatorseite (15) erzeugt, umfasst, wobei die Barriere (18) so ausgestaltet ist, dass sie den ersten Luftstrom (14) und den zweiten Luftstrom (17) trennt.

7. Wärmetauscher (10) gemäß einem der vorhergehenden Ansprüche, wobei die Kanäle (38) eine Querabmessung (40) von 0,1 mm bis 12 mm, vorzugsweise 0,2 mm bis 10 mm, weiter bevorzugt 0,4 mm bis 6 mm, am meisten bevorzugt 2 mm bis 5 mm, aufweisen.

8. Wärmetauscher (10) gemäß einem der vorhergehenden Ansprüche, wobei die Kanäle (38) teilweise mit einem Kühlmittel (44) gefüllt sind.

9. Wärmetauscher (10) nach einem der vorhergehenden Ansprüche, wobei der Wärmetauscher (10) Metallplatten (47) umfasst, die zwischen benachbarten Kanälen (38) angeordnet sind.

10. Wärmetauscher (10) gemäß einem der vorhergehenden Ansprüche, wobei die
Kondensatoreinheit (32) größer als die Verdampfereinheit (31) ausgestaltet ist.

11. Verwendung eines Wärmetauschers (10) gemäß den Ansprüchen 1 bis 10 zum
Kühlen eines Elektronikgehäuses (90).

## Revendications

1. Echangeur de chaleur (10) pour refroidir une enceinte électronique (90),
comprenant un côté de condenseur (15) et un côté d'évaporateur (12),
sachant que l'échangeur de chaleur (10) comporte un élément d'échange de chaleur (30) possédant une unité de condenseur (32) et une unité d'évaporateur (31),
sachant que l'unité d'évaporateur (31) comprend une zone d'extrémité supérieure (31a), une zone d'extrémité inférieure (31b) et une pluralité (37) de conduits (38) pour transporter un réfrigérant (44) de la zone d'extrémité inférieure (31b) à la zone d'extrémité supérieure (31a), ledit réfrigérant (44) comportant du liquide (58) et du gaz (59),
sachant que l'élément d'échange de chaleur (30) est un thermosiphon (30a),
sachant que l'unité de condenseur (32) et l'unité d'évaporateur (31) sont disposées de telle manière que l'unité de condenseur (32) et l'unité d'évaporateur (31) se chevauchent verticalement,
et sachant que l'unité de condenseur (32) possède une zone d'extrémité supérieure (32a), une zone d'extrémité inférieure (32b) et une pluralité (37) de conduits (38), sachant que l'élément d'échange de chaleur (30) possède une deuxième ligne (42) pour transporter du gaz (59) de la zone d'extrémité supérieure (31a) de l'unité d'évaporateur (31) à la zone d'extrémité supérieure (32a) de l'unité de condenseur (32), **caractérisé en ce que**
la zone d'extrémité supérieure (31a) de l'unité d'évaporateur (31) est raccordée à la zone d'extrémité inférieure (31b) de l'unité d'évaporateur (31) par une première ligne (41), ladite première ligne (41) étant configurée pour transférer uniquement du liquide (58) de la zone d'extrémité supérieure (31a) à la zone d'extrémité inférieure (31b) et **en ce que**
la zone d'extrémité supérieure (31a) de l'unité d'évaporateur (31) est configurée pour laisser le liquide (58) et le gaz (59) étant transportés vers ladite zone d'extrémité supérieure (31a) au moyen de la pluralité de conduits (38) séparés les uns des autres pour former une phase liquide continue (58b) et une phase gazeuse continue (59b) de telle sorte que du liquide (58) peut couler en retour vers la zone d'extrémité inférieure (31b) de l'unité d'évaporateur (31) au moyen de la première ligne (41).

2. Echangeur de chaleur (10) selon la revendication 1,
sachant que la zone d'extrémité supérieure (31a) de l'unité d'évaporateur (31) est configurée en forme de cuvette, sachant que la première ligne (41) est configurée comme une évacuation (61).

3. Echangeur de chaleur (10) selon l'une quelconque des revendications précédentes,
sachant que le côté de condenseur (15) est situé plus haut que le côté d'évaporateur (12).

4. Echangeur de chaleur (10) selon la revendication 1,
sachant que l'élément d'échange de chaleur (30) possède une troisième ligne (43) pour transporter du liquide (58) de la zone d'extrémité inférieure (32b) de l'unité de condenseur (32) à la zone d'extrémité inférieure (31b) de l'unité d'évaporateur (31).

5. Echangeur de chaleur (10) selon l'une quelconque des revendications précédentes,
sachant que le côté de condenseur (15) et le côté d'évaporateur (12) sont séparés l'un de l'autre par une barrière (18).

6. Echangeur de chaleur (10) selon l'une quelconque des revendications précédentes,
sachant que l'échangeur de chaleur (10) comporte un ventilateur d'évaporateur (13) configuré pour produire un premier courant d'air (14) sur le côté d'évaporateur (12) et un ventilateur de condenseur (16) configuré pour produire un deuxième courant d'air (17) sur le côté de condenseur (15), sachant que la barrière (18) est configurée pour séparer le premier courant d'air (14) et le deuxième courant d'air (17).

7. Echangeur de chaleur (10) selon l'une quelconque des revendications précédentes,
sachant que les conduits (38) ont une dimension transversale (40) de 0,1 mm à 12 mm, de préférence de 0,2 mm à 10 mm, de préférence en plus de 0,4 mm à 6 mm, de la façon la plus préférée de 2 mm à 5 mm.

8. Echangeur de chaleur (10) selon l'une quelconque des revendications précédentes,
sachant que les conduits (38) sont remplis en partie avec un réfrigérant (44).

9. Echangeur de chaleur (10) selon l'une quelconque des revendications précédentes,
sachant que l'échangeur de chaleur (10) comporte des plaques métalliques (47) étant disposées entre des conduits voisins (38).

10. Echangeur de chaleur (10) selon l'une quelconque des revendications précédentes,
sachant que l'unité de condenseur (32) est configurée plus grande que l'unité d'évaporateur (31).

11. Utilisation d'un échangeur de chaleur (10) selon les revendications 1 à 10 pour refroidir une enceinte électronique (90).
